# EUROPEAN PATENT APPLICATION

(11) **EP 1 804 202 A1**
(43) Date of publication of application: **04.07.2007**
(21) Application number: 06000045.2
(22) Date of filing: 02.01.2006
(51) Int. Cl.: G06K 19/077, H05K 3/00, H05K 1/11, H05K 3/24, H01L 23/498

(54) **Tape carrier and module for contact type IC card and method for manufacturing the tape carrier**

(71) Applicant: TIBC CORPORATION, Obu-shi Aichi-ken 474-8601 (JP)
(72) Inventor: Furuta, Tetsuya, Obu-shi, Aichi-ken 474-8601 (JP)
(74) Representative: Geyer, Fehners & Partner

(57) **Abstract**

A tape carrier (30) for a contact type IC card including a substrate (32), made of an insulative material such as polyethylene terephthalate, and a plurality of pad groups (20), arranged on a first surface (F) of the substrate. Each of the pad groups includes a plurality of contact pads. The substrate is cut along a punching line (L) surrounding each pad group. The pad groups are formed on the first surface without a conductor extending across the punching line. This eliminates the need for plating lead lines, which would be required when performing electroplating and which would extend from the pad groups across the punching line.

## Description

The present invention relates to a tape carrier and a module for a contact type IC card and a method for manufacturing the tape carrier.

Japanese Laid-Open Patent Publication No. 7-202380 describes a typical contact type IC card tape carrier. The tape carrier is used to form modules incorporated in contact type IC cards. The tape carrier includes a strip-shaped substrate (printed wiring board) and a plurality of contact pad groups formed on the surface of the substrate. Each contact pad group corresponds to one of the modules.

IC chip regions, in which IC chips are arranged, and a plurality of bonding holes, are provided on the substrate at portions corresponding to the contact pad groups. The substrate has a thickness of 100 µm and is made of glass epoxy.

Contact pads, which form each contact pad group, are made of, for example, copper, and adhered to the surface of the substrate with an adhesive. Copper foil is adhered to the substrate with the adhesive. Then, the copper foil is, for example, etched to form the contact pads. Further, electroplating is performed to apply a plating surface, which is made of nickel or gold, on the surfaces of the contact pads.

To enable electroplating, plating lead lines connected to the contact pads are arranged on the substrate of the tape carrier. When the copper foil is etched, the plating lead lines and the contact pads are formed at the same time. The plating lead lines include a main lead and a secondary lead line. The main lead line extends in the longitudinal direction of the tape carrier along the two sides of the tape carrier. The secondary lead line electrically connects the contact pads on the tape carrier to the main lead line. When performing electroplating, current is supplied to the contact pads through the plating lead lines so that the contact pads function as anodes.

The modules are punched out from the substrate, which includes the pad groups, along a punching line surrounding each pad group. In this manner, the modules are obtained from the tape carrier. After the punching, an IC chip is arranged in the IC chip region defined in each punched out portion of the substrate. Subsequently, wire bonding is performed to connect the IC chip to the contact pads on the punched out portion of the substrate. This completes the module. Then, the module is incorporated in an IC card. The IC card is inserted into an IC card reader. In this state, terminals of the reader come into contact with the contact pads of the module so that data is readable from the IC chip of the module.

As described above, punching is performed on the tape carrier along the punching line of the substrate to obtain the modules. However, the plating lead lines, which are required to perform electroplating, extend from the contact pads and across the punching line. Thus, when the tape carrier undergoes punching, the plating lead lines are cut along the punching line, and the cut portions of the plating lead lines become easily separated from the substrate. Insertion of the IC card, incorporating such a module, into an IC card reader may result in further separation of the plating lead lines. This may separate the contact pads, to which the plating lead lines are connected, from the substrate. This would lower the reliability of the IC card that incorporates such a module.

It is an object of the present invention to provide a tape carrier and a module for a contact type IC card having improved reliability and a method for manufacturing the tape carrier.

One aspect of the present invention is a tape carrier for a contact type IC card. The tape carrier includes a substrate, made of an insulative material, and a plurality of pad groups, arranged on a first surface of the substrate. Each of the pad groups includes a plurality of contact pads, and the substrate is adapted to be cut along a cutting line surrounding each of the pad groups. The pad groups are formed on the first surface without a conductor extending across the cutting line.

Another aspect of the present invention is a module for a contact type IC card. The module is obtained by cutting the tape carrier described above along the cutting line.

Further aspect of the present invention is a method for manufacturing a tape carrier for a contact type IC card. The method includes: preparing a substrate made of an insulative material; forming a plurality of pad groups on a first surface of the substrate, wherein each of the pad groups includes a plurality of contact pads, and the substrate is adapted to be cut along a cutting line surrounding each of the pad groups; and forming a plating layer on the surface of the pad groups by performing electroless plating.

Other aspects and advantages of the present invention will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:
Fig. 1 is a plan view showing an IC card according to a preferred embodiment of the present invention;
Fig. 2A is an enlarged plan view showing a module arranged in the IC card of Fig. 1;
Fig. 2B is a cross-sectional view taken along line 2B-2B in Fig. 2A;
Fig. 3 is a rear perspective view showing the module of Fig. 2A;
Fig. 4 is a cross-sectional view showing a substrate and a pad group in the module of Fig. 2A;
Fig. 5 is a plan view showing a tape carrier;
Fig. 6 is a plan view showing a pad group in a modification of the preferred embodiment;
Fig. 7 is a cross-sectional view showing a pad group in another modification of the preferred embodiment; and
Figs. 8A and 8B are cross-sectional views showing modules in further modifications of the preferred embodiment.

A preferred embodiment of the present invention will now be discussed.

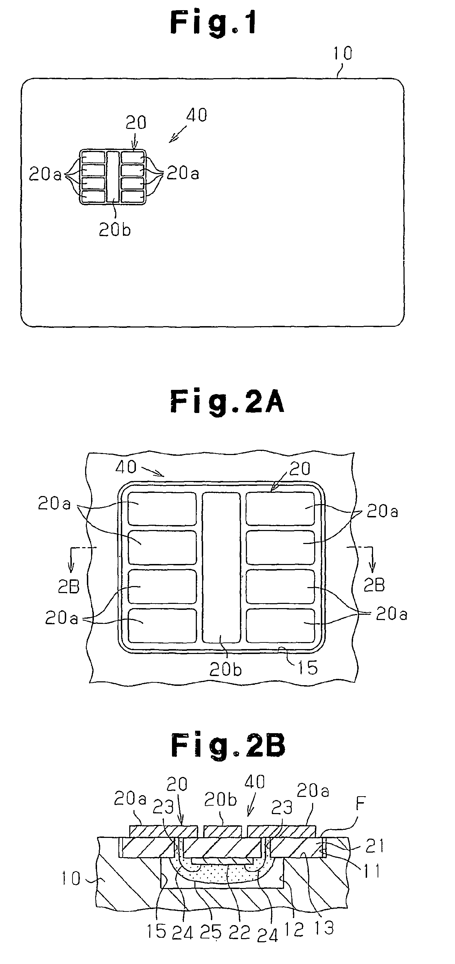

The structure of a contact type IC card will first be described with reference to Fig. 1. As shown in Fig. 1, the IC card includes a card body 10 and a module 40, which is arranged on the card body 10.

The card body 10 is made of, for example, a polyvinyl chloride resin, and has a surface in which patterns or characters are printed. The module 40 is adhered to the card body 10 with, for example, an adhesive.

Referring to Figs. 2A and 2B, the card body 10 includes a rectangular accommodation recess 15 for accommodating the module 40. The accommodation recess 15 includes a shallow hollow portion 11 and a deep hollow portion 12, which has a smaller side cross-section than the shallow hollow portion 11. A stepped portion 13 is defined between the shallow hollow portion 11 and the deep hollow portion 12. The module 40 is arranged in the accommodation recess 15 in a state fixed to the stepped portion with an adhesive or the like.

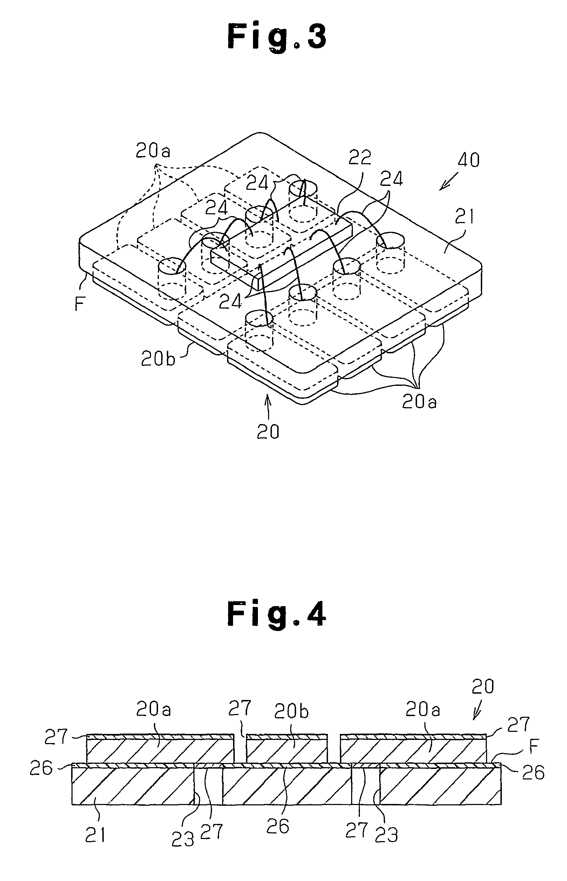

Referring to Figs. 2A, 2B and 3, the module 40 includes a substrate 21 (printed wiring board), which is made of an insulative material, and a pad group 20, which is arranged on a front surface (first surface) F of the substrate 21. The pad group 20 includes a plurality of contact pads 20a and 20b (nine in the preferred embodiment) for contacting terminals of an IC card reader (not shown). The contact pad 20b located in the middle functions as a ground terminal.

An IC chip 22, which functions as an electronic component, is arranged on the surface of the substrate 21 opposite the first surface F (rear surface). The substrate 21 has a thickness of, for example, 50 µm and is made of polyethylene terephthalate (PET). Further, the substrate 21 includes a plurality of wire bonding holes 23 (through holes without plating). Lead lines 24 extend through the wire bonding holes 23 to electrically connect the contact pads 20a and the IC chip 22. The IC chip 22 and the lead lines 24 are covered by an encapsulation resin 25, which is, for example, an epoxy resin.

Referring to Fig. 4, an adhesive layer 26, which is made of an ultraviolet ray curing adhesive, is applied to the first surface F of the substrate 21. The contact pads 20a and 20b are bonded to the substrate 21 with the adhesive layer 26. The contact pads 20a and 20b are formed from an aluminum foil, which conducts electricity. The conductive foil undergoes a treatment for adding a corrosive resistance property and a wear resistance property to the surface of the conductive foil. More specifically, a plating layer 27 is formed to add corrosive and wear resistance properties to the surfaces of the contact pads 20a and 20b (at portions for contacting the terminals of an IC card reader and portions exposed in the wire bonding holes 23). The plating layer 27 is made of, for example, nickel and formed by performing electroless plating. The plating layer 27, which is formed through electroless plating, is not limited to nickel. Any metal that is suitable for enabling bonding of the lead lines 24 may be used. For example, gold, silver, nickel copper, palladium, or tin may be used.

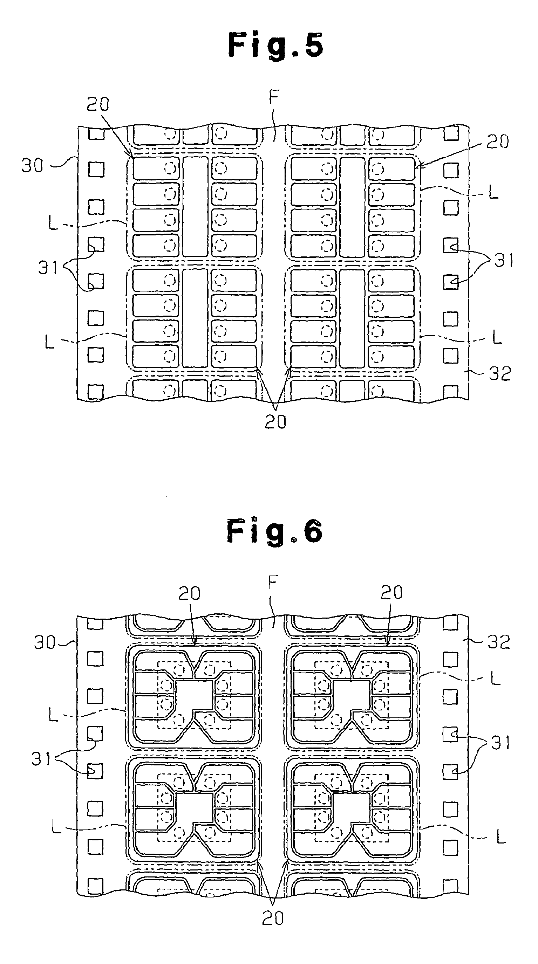

Referring to Fig. 5, the module 40 is formed by punching a tape carrier 30. The tape carrier 30 includes a strip-shaped substrate 32 (printed wiring board), which is made of an insulative material. A plurality of pad groups 20 are formed on the front surface (first surface) F of the substrate 32. The pad groups 20 are arranged in two rows in the longitudinal direction of the substrate 32. The substrate 32 of the tape carrier 30 corresponds to the substrate 21 of the module 40. The substrate 32 includes a plurality of wire bonding holes 23 in correspondence with each pad group 20.

Sprocket holes 31 are formed in the two sides of the substrate along the longitudinal direction of the substrate 32. Sprockets of a feeder (not shown) are rotated in a state engaged with the sprocket holes 31 to move the tape carrier 30 in the longitudinal direction and transfer the pad groups 20 of the tape carrier 30.

The formation of the pad groups 20 on the substrate 32 of the tape carrier 30 will now be described. The adhesive layer 26 is applied to the front surface of the substrate 32. Then, the wire bonding holes 23 and the sprocket holes 31 are formed in the substrate 32, which includes the adhesive layer 26. Next, the pad groups 20 are formed on the substrate 32. More specifically, a conductive foil (aluminum foil) patterned in correspondence with the pad groups 20 is put on the adhesive layer 26. Then, the adhesive layer 26 is irradiated with ultraviolet rays and hardened. This fixes the conductive foil patterned in correspondence with the pad groups 20 on the substrate 32 with the adhesive layer 26. If the conductive foil is made of a material that is suitable for etching (e.g., copper), after fixing the conductive foil to the substrate 32 with the adhesive layer 26, the conductive foil may undergo etching and be patterned in correspondence with the pad groups 20. Subsequently, electroless plating is performed to form the plating layer 27 (nickel plating layer) on the surfaces of the contact pads 20a and 20b, which form the pad groups 20.

In Fig. 5, the double-dotted lines represent a punching line L (cutting line). Punching (cutting) is performed along the punching line L with a punching die (not shown) to obtain the module 40 (refer to Fig. 4), which includes a pad group 20 formed on the substrate 21. Adjacent pad groups 20 are spaced such as to prevent the pad groups 20 from becoming deficient due to, for example, damage inflicted during the punching. Subsequent to the punching, the IC chip 22 is mounted to the rear surface of the substrate 21, and the pad group 20 is connected to the IC chip 22 by the lead lines 24. This completes the module 40. The IC chip may be mounted prior to the punching of the substrate 32.

The preferred embodiment has the advantages described below.

The contact pads 20a and 20b including the plating layer 27 is arranged on the first surface F of the substrate 21 in the module 40. In the preferred embodiment, electroless plating is performed to form the plating layer 27 on the contact pads 20a and 20b, which are arranged on the substrate 32 of the tape carrier 30. This eliminates the need for plating lead lines, which would be required when performing electroplating and which would extend from the contact pads 20a and 20b and across the punching line L. In other words, the pad groups 20 are formed on the substrate 32 without any conductors extending across the punching line L on the substrate 32. This prevents the occurrence of a problem in which cut ends of plating lead lines are separated from the substrate when the plating lead lines are cut along the plating line during the punching of a tape carrier.

In comparison with when using plating lead lines, the distance between adjacent pad groups 20 on the substrate 32 of the tape carrier may be reduced. This enables an increase in the number of pad groups 20 arranged on the tape carrier 30. Further, the remainder of the substrate 32 subsequent to punching is disposed of as waste. However, there are no conductors, such as plating lead lines, in the remainder of the substrate 32. This facilitates recycling of the waste.

The substrate 32 (substrate 21) is made of polyethylene terephthalate (PET). Polyethylene terephthalate is less expensive than glass epoxy, which is normally used as a substrate material. Further, when using the polyethylene terephthalate substrate 32 (substrate 21), in comparison with when using a glass epoxy substrate, less dust is produced during punching and less wear occurs on the punching die.

The thickness of a glass epoxy substrate is normally 100 µm. However, the thickness of the polyethylene terephthalate substrate 32 (substrate 21) may be reduced to 50 µm or less, that is, one half of that of a glass epoxy substrate. This enables the thickness of the substrate 32 (substrate 21) to be reduced. Thus, the substrate 32 (substrate 21) is suitable for use in an IC card of which thickness is limited. The thickness of the substrate 32 (substrate 21) may be selected from a range of 50 µm or less, for example, 50 µm or 25 µm, in accordance with the purpose of use.

The contact pads 20a and 20b are bonded to the substrate 32 (substrate 21) with the adhesive layer 26, which is made of an ultraviolet ray curing adhesive. The polyethylene terephthalate substrate 32 (substrate 21) is susceptible to heat. Thus, the use of an ultraviolet ray curing adhesive instead of a heat curing adhesive is advantageous for performing bonding in a preferable manner.

The contact pads 20a and 20b are formed from an aluminum foil of which surface includes the plating layer 27. In other words, a treatment for adding corrosion and wear resistance properties is performed on the surface of the aluminum foil, which forms the contact pads 20a and 20b. The aluminum foil is inexpensive and thus lowers the cost for the tape carrier 30. Further, in addition to improving the corrosion and wear resistance, the arrangement of the plating layer 27 on the surface of the contact pads 20a and 20b ensures satisfactory conduction between the contact pads 20a and 20b and the terminals of an IC card reader. This also enables the bonding of the lead lines 24 to the contact pads 20a and 20b in a preferable manner.

It should be apparent to those skilled in the art that the present invention may be embodied in many other specific forms without departing from the spirit or scope of the invention. Particularly, it should be understood that the present invention may be embodied in the following forms.

The contact pads 20a and 20b of the pad group 20 does not have to be patterned in the manner shown in Fig. 5 and may be patterned in any manner, for example, as shown in Fig. 6.

The arrangement of the pad groups 20 on the tape carrier 30 is not limited to the manner shown in Fig. 5 and may be changed in any manner. For example, in Fig. 5, the orientation of the pad groups 20 relative to the tape carrier 30 may be changed by 90 degrees. Further, in Fig. 5, the pad groups 20 are formed in two rows in the longitudinal direction of the tape carrier 30. However, as long as there is at least one row, the pad groups 20 may be arranged in any number of rows. For example, the pad groups 20 may be arranged in a single row or three or more rows in the longitudinal direction of the tape carrier 30.

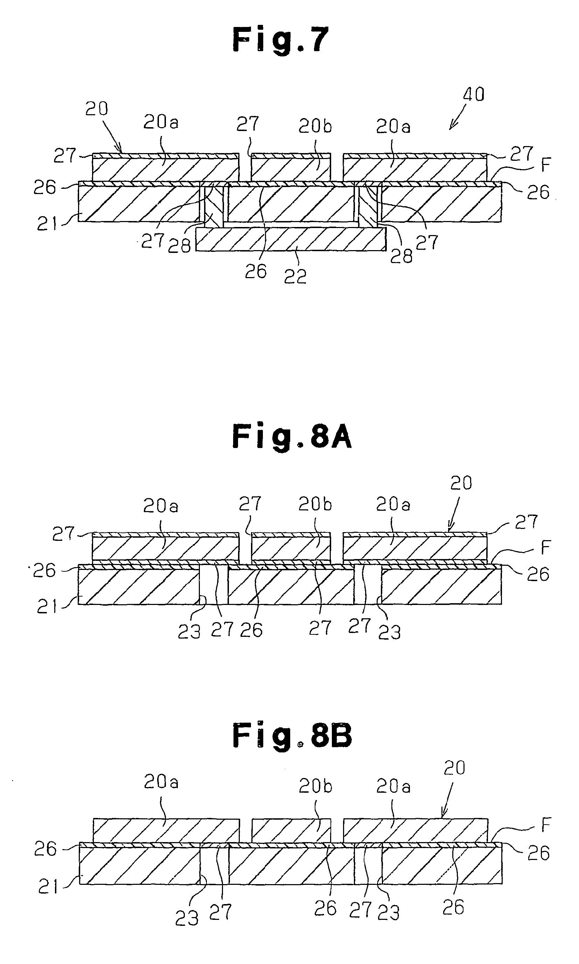

The mounting of the IC chip 22 to the substrate 32 (substrate 21) is not limited to the manner shown in Fig. 3 and may be changed as required. For example, referring to Fig. 7, a flip-chip mount technology may be used to mount the IC chip 22. More specifically, as shown in Fig. 7, the IC chip 22 may be arranged on the side of the substrate 32 (substrate 21) opposite to the first surface F, which includes the pad group 20. The IC chip 22 is connected to the contact pads 20a by bumps 28, which extend through the substrate 32 (substrate 21). The bumps 28 are formed through, for example, soldering. In the structure shown in Fig. 7, the bonding holes 23 function as through holes, through which the bumps 28 extend.

In the preferred embodiment, subsequent to the formation of the contact pads 20a and 20b on the substrate 32, the plating layer 27 is formed on the surface of the contact pads 20a and 20b. However, for example, electroless plating may be performed to form a nickel plating layer 27 on the two sides of an aluminum foil, which conducts electricity. Then, the foil may be used to form the contact pads 20a and 20b on the substrate 32.

Referring to Fig. 8B, a conductive foil made of stainless steel may be used as the material for the contact pads 20a and 20b. Stainless steel conductive foil has superior corrosion and wear resistance properties. Thus, the plating layer 27 may be formed only on the contact pads 20a, which undergo wire bonding.

In the preferred embodiment, the substrate 32 (substrate 21) is made of polyethylene terephthalate, the adhesive layer 26 is made of an ultraviolet ray curing adhesive, and the contact pads 20a and 20b are made of an aluminum conductive foil. However, for example, the substrate 32 (substrate 21) may be made of glass epoxy, the adhesive layer 26 may be made of a heat curing adhesive, and the contact pads 20a and 20b may be made of a copper or nickel conductive foil. The combination of these materials may be determined in any manner in accordance with the purpose of use from the viewpoint of reliability, cost, recyclability, and the like.

The present examples and embodiments are to be considered as illustrative and not restrictive, and the invention is not to be limited to the details given herein, but may be modified within the scope and equivalence of the appended claims.

## Claims

1. A tape carrier for a contact type IC card, the tape carrier including a substrate, made of an insulative material, and a plurality of pad groups, arranged on a first surface of the substrate, wherein each of the pad groups includes a plurality of contact pads, and the substrate is adapted to be cut along a cutting line surrounding each of the pad groups, the tape carrier being **characterized in that**:
the pad groups are formed on the first surface without a conductor extending across the cutting line.

2. The tape carrier according to claim 1, **characterized in that** only the pad groups are formed on the first surface.

3. The tape carrier according to claim 1 or 2, **characterized in that** the substrate is made of polyethylene terephthalate.

4. The tape carrier according to any one of claims 1 to 3, **characterized in that** the pad groups are adhered to the substrate with an ultraviolet ray curing adhesive.

5. The tape carrier according to any one of claims 1 to 4, **characterized in that** each of the pad groups is formed from a conductive foil, and a plating layer formed through electroless plating is formed on the surface of the conductive foil.

6. The tape carrier according to any one of claims 1 to 4, **characterized in that** each of the pad groups is formed from an electrically conductive foil, and the conductive foil is an aluminum foil having a surface that has undergone treatment for adding a corrosion resistance property and a wear resistance property.

7. The tape carrier according to any one of claims 1 to 5, **characterized in that** each of the pad groups is made of aluminum or stainless steel.

8. The tape carrier according to any one of claims 1 to 7, **characterized in that** the pad groups are arranged in at least one row in the longitudinal direction of the substrate, and the substrate includes sprocket holes arranged in the longitudinal direction of the substrate and a plurality of through holes respectively corresponding to the pad groups, each through hole allowing passage of a conductor for connecting the corresponding pad group to an electronic component arranged on a side of the substrate opposite to the first surface.

9. A module for a contact type IC card, the module being obtained by cutting the tape carrier according to any one of claims 1 to 8 along the cutting line.

10. The module according to claim 9, **characterized in that** an electronic component is arranged on a side of the substrate opposite to the first surface, the electronic component being connected to the pad groups by bumps extending through the substrate.

11. A method for manufacturing a tape carrier for a contact type IC card, the method being **characterized by**:
preparing a substrate made of an insulative material;
forming a plurality of pad groups on a first surface of the substrate, wherein each of the pad groups includes a plurality of contact pads, and the substrate is adapted to be cut along a cutting line surrounding each of the pad groups; and
forming a plating layer on the surface of the pad groups by performing electroless plating.

12. The method according to claim 11, **characterized in that** the substrate is made of polyethylene terephthalate, and the pad groups are adhered to the substrate with an ultraviolet ray curing adhesive.

13. The method according to claim 11 or 12, **characterized in that** each of the pad groups is formed from an aluminum foil, and the plating layer is a nickel plating layer.
